# EUROPEAN PATENT APPLICATION

(11) **EP 2 207 220 A2**
(43) Date of publication of application: **14.07.2010**
(21) Application number: 10150272.2
(22) Date of filing: 07.01.2010
(51) Int. Cl.: H01L 51/52

(54) **Organic light emitting diode display with a mirror function**

(30) Priority: 09.01.2009 KR 20090001910
(71) Applicant: Samsung Mobile Display Co., Ltd., Yongin-City Gyunggi-do (KR)
(72) Inventor: Jung, Woo-Suk, Gyunggi-Do (KR); Park, Soon-Ryong, Gyunggi-Do (KR); Park, Jun-Ho, Gyunggi-Do (KR)
(74) Representative: Gulde Hengelhaupt Ziebig & Schneider

(57) **Abstract**

The present disclosure relates to an organic light emitting diode (OLED) display having a mirror function to reflect external light for when the OLED display does not emit light. The organic light emitting diode display includes a substrate member, an organic light emitting element formed on the substrate member, a phase retardation plate formed on the organic light emitting element, and a selective reflective layer formed on the phase retardation plate. The selective reflective layer selectively passes some light from outside and reflects the rest.

## Description

### BACKGROUND OF THE DISCLOSURE

### Field Disclosure

The present disclosure relates to an organic light emitting diode (OLED) display. More particularly, the present disclosure relates to an organic light emitting diode (OLED) display having a mirror function.

### Description of the Related Art

An organic light emitting diode display is a self-emitting type of display. Thus, unlike a liquid crystal display, an organic light emitting diode display does not require an additional light source, and therefore the thickness and weight thereof can be reduced. Further, since an organic light emitting diode (OLED) display shows favorable characteristics, such as low power consumption, high luminance, and high reaction speed, OLED displays have attracted considerable attention for several applications, such as display devices for portable electronic devices.

In recent years, the organic light emitting diode display has been improved to have various additional functions, such as a mirror function. That is, when the organic light emitting diode display does not display an image, the organic light emitting diode display can be used as a mirror or reflect light like a mirror. Typically, in order to provide this function, a thin metallic film is implemented in the OLED display. However, the known OLED displays having the mirror function have remarkably low transmittance and visibility.

The above information disclosed in this Background section is only for enhancement of understanding of the background of the disclosure and therefore it may contain information that does not form the prior art that is already known in this country to a person of ordinary skill in the art.

### SUMMARY OF THE DISCLOSURE

The present disclosure has been made in an effort to provide various embodiments of an organic light emitting diode display that has proper transmittance and visibility while having a mirror function. Accordingly the invention provides the organic light emitting diode display of claim 1. Preferred embodiments are subject of the dependent claims.

### BRIEF DESCRIPTION OF THE DRAWINGS

The present disclosure will be described more fully hereinafter with reference to the accompanying drawings, in which some embodiments of the disclosure are shown. In the Figures:

FIG. 1 is a partial cross-sectional view of an organic light emitting display device according to a first embodiment of the present disclosure.

FIG. 2 is a layout view illustrating a pixel circuit of the organic light emitting diode display of FIG. 1.

FIG. 3 is a configuration diagram illustrating the path of light from outside of the organic light emitting diode display of FIG. 1.

FIG. 4 is a configuration diagram illustrating the path of light emitted from the organic light emitting element of the organic light emitting diode display of FIG. 1.

FIG. 5 is a partial cross-sectional view of an organic light emitting display device according to a second embodiment of the present disclosure.

FIG. 6 is a configuration diagram illustrating the path of light from outside of the organic light emitting diode display of FIG. 5 and the path of light emitted from an organic light emitting element.

FIG. 7 is a partial cross-sectional view of an organic light emitting display device according to a third embodiment of the present disclosure.

FIG. 8 is a configuration diagram illustrating the path of light from outside to the organic light emitting diode display of FIG. 7.

FIG. 9 is a configuration diagram illustrating the path of light emitted from an organic light emitting element of the organic light emitting diode display of FIG. 7.

FIG. 10 is a partial cross-sectional view of an organic light emitting display device according to a fourth embodiment of the present disclosure.

FIG. 11 is a configuration diagram illustrating the path of light from outside to the organic light emitting diode display of FIG. 10.

FIG. 12 is a configuration diagram illustrating the path of light emitted from an organic light emitting element of the organic light emitting diode display of FIG. 10.

### DETAILED DESCRIPTION

As those skilled in the art would realize, the described embodiments may be modified in various different ways, all without departing from the spirit or scope of the present disclosure. In some embodiments, constituent elements having the same configuration are representatively described in a first embodiment by using the same reference numerals, and only constituent elements other than the constituent elements described in the first embodiment will be described in other embodiments. In order to clarify the present disclosure, elements extrinsic to the description are omitted and like reference numerals refer to like elements throughout the specification.

Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity and convenience of description. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Although an active matrix (AM) type of organic light emitting diode display having a 2Tr-1Cap structure with two thin film transistors (TFTs) and one storage capacitor in one pixel is shown, embodiments of the present disclosure are not limited to this type of display. For example, the organic light emitting diode display may be provided with three or more thin film transistors and two or more storage capacitors in one pixel, and may be configured to have various structures with additional wires. Herein, the pixel represents a minimum unit displaying an image, and the organic light emitting diode display displays the image by means of a plurality of pixels.

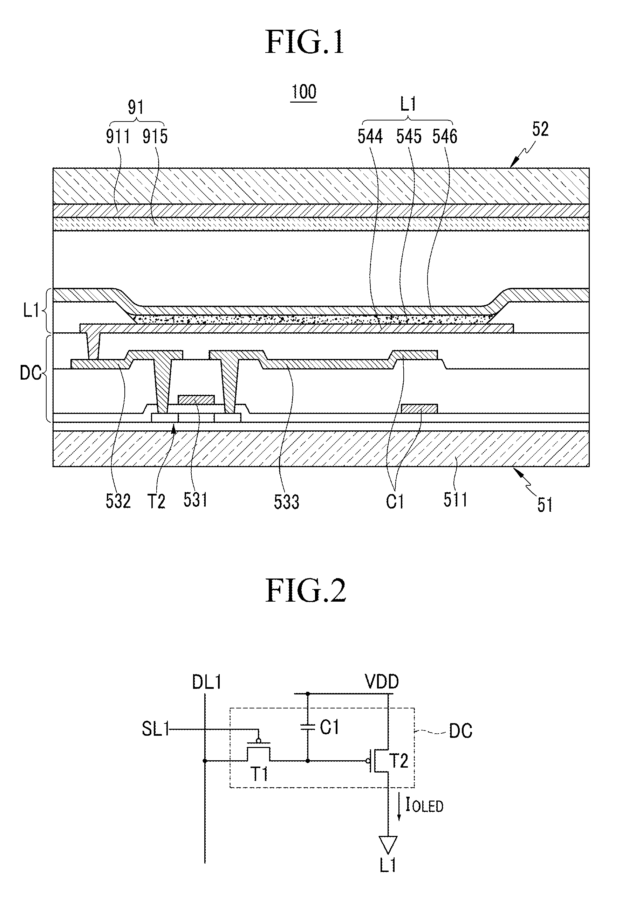

Referring now to FIGS. 1 and 2, a first illustrated embodiment of the present disclosure will be described. As shown in FIGS. 1 and 2, an organic light emitting diode (OLED) display 100 includes a first substrate 51, a second substrate 52, and an optical member 91 that are bonded with each other. The first substrate 51 includes a substrate member 511, a driving circuit DC formed on the substrate member 511, and an organic light emitting element L1 formed on the driving circuit DC.

The driving circuit DC has a layout structure as shown in FIG. 2. FIG. 2 shows a circuit layout state of one pixel in the driving circuit DC. As shown, the driving circuit DC can include two or more thin film transistors and at least one storage capacitor, such as storage capacitor C1. The thin film transistors include a switching transistor T1 and a driving transistor T2.

The switching transistor T1 is connected to a scan line SL1 and a data line DL1. The switching transistor T1 transmits a data voltage inputted from the data line DL1 to the driving transistor T2 depending on a switching voltage inputted to the scan line SL1. The storage capacitor C1 is connected to the switching transistor T1 and a power supply line VDD. The storage capacitor C1 stores a voltage corresponding to a difference between a voltage transmitted from the switching transistor T1 and a voltage supplied from the power supply line VDD.

Referring back to FIG. 1, the driving transistor T2 includes a source electrode 533, a drain electrode 532, and a gate electrode 531. The driving transistor T2 is connected to the power supply line VDD and the storage capacitor C1. The driving transistor supplies an output current I_{OLED} that is proportional to the square of a difference between the voltage stored in the storage capacitor C1 and a threshold voltage to the organic light emitting element L1. The organic light emitting element L1 emits light by the output current I_{OLED}.

The organic light emitting element L1 formed on the driving circuit DC includes a first electrode 544, an organic emission layer 545 formed on the first electrode 544, and a second electrode 546 formed on the organic emission layer 545. In general, the first electrode 544 can be an anode electrode and the second electrode 546 can be a cathode electrode. However, the first embodiment is not limited to this configuration, and the first electrode 544 may be the cathode electrode and the second electrode 546 may be the anode electrode according to a driving method. In addition, the first electrode 544 of the organic light emitting element L1 can be connected to the drain electrode 532 of the driving transistor T2.

One or more of the first electrode 544 and the second electrode 546 is formed of a semi-transmissive or reflective type to reflect light. The organic light emitting element L1 emits light from the organic emission layer 545 to the second electrode 546 to display images. That is, the organic light emitting diode display 100 is formed as a top emission type. The configurations of the driving circuit DC and the organic light emitting element L1 are not limited to the above-mentioned example, but may be modified in various known configurations that can be implemented by those skilled in the art.

In the illustrated embodiment, an optical member 91 is provided to reflect light when the OLED display is not emitting light. The optical member 91 can be formed on the first substrate 51. The optical member 91 is formed in a direction where the organic light emitting element L1 emits light and configured to reflect external light when the organic light element L1 does not emit light. The optical member 91 can include a phase retardation plate 915 formed on the organic light emitting element L1, and a selective reflective layer 911 formed on the phase retardation plate 915. The optical member 91 can be configured to minimize loss of light emitted from the organic light emitting element L1 to outside while improving visibility of the organic light emitting diode display 100 by suppressing external light reflection. Further, the optical member 91 has an effect like a mirror by reflecting external light when the organic light emitting element L1 does not emit light. Therefore, the organic light emitting diode display 100 may have a mirror function.

A dual brightness enhancement brightness film (DBEF) can be used as the selective reflective layer 911. The dual brightness enhancement film (DBEF) 911 passes light that is parallel to a polarization axis and reflects light that is not parallel to the polarization axis. Accordingly, the light passing through the dual brightness enhancement film 911 is linearly polarized in the polarization axis of the dual brightness enhancement film 911. Further, the dual brightness enhancement film 911 has an effect of a mirror by reflecting external light when the organic light emitting element L1 does not emit light, such that the organic light emitting diode display 100 has a mirror function.

The phase retardation plate 915 can be a 1/4 wavelength plate. The phase retardation plate 915 has an optical axis that deviates from the polarization axis of the polarizing plate 911 from about 40 to about 50 degrees. That is, an intersection angle between an optical axis of the phase retardation plate 915 and the polarization axis of the dual brightness enhancement film 911 can be about 40 to about 50 degrees.

In addition, the phase retardation plate 915 circularly polarizes the light linearly polarized through the dual brightness enhancement film 911. As such, an intersection angle between the optical axis of the phase retardation plate 915 and the polarization axis of the dual brightness enhancement film 911 can be about 45 degrees, such that the phase retardation plate 915 circularly polarizes the light that is linearly polarized through the dual brightness enhancement film 911. That is, as the intersection angle between the optical axis of the phase retardation plate 915 and the polarizing axis of the dual brightness enhancement film 911 becomes closer to about 45 degrees, the linear polarized light passing through the polarizing plate 911 becomes substantially circular polarized light while passing through the phase retardation plate 915. However, since the light shows slightly different movements for each wavelength band, the intersection angle has an error tolerance of approximately plus or minus 5 degrees. Accordingly, the polarization axis of the dual brightness enhancement film 911 and the optical axis of the phase retardation plate 915 are arranged on the basis of light of the visible wavelength. However, the polarization axis of the film 911 and the optical axis of retardation plate 915 can be arranged for various wavelengths of light.

In the illustrated first embodiment, the second substrate 52 covers the first substrate 51 on which the organic light emitting element L1 and the driving circuit DC are disposed. That is, the second substrate 52 is arranged opposite to the first substrate 51 to cover the thin film transistors T1 and T2, the storage capacitor C1, and the organic light emitting element L1. The second substrate 52 is bonded with the first substrate 51 by a sealant (not shown) formed on the edge. That is, the first substrate 51 and the second substrate 52 are bonded with each other to seal a space therebetween. The film transistors T1 and T2, the capacitor C1, and the organic light emitting element L1 can be sealed within the space. Further, the second substrate 52 also covers the optical member 91 formed on the organic light emitting element L1. However, the first embodiment of the present disclosure is not limited to this configuration.

For example, the optical member 91 may alternatively be formed on the second substrate 52. That is, the optical member 91 may be disposed outside of the sealed space formed by bonding of the first substrate 51 and the second substrate 52 with each other. As such, the optical member 91 may be arbitrarily disposed on the organic light emitting element L1. The second substrate 52 can be a transparent insulating substrate made of a material, such as glass or plastic.

By this configuration, the organic light emitting diode display 100 may have the mirror function. Further, the organic light emitting diode display 100 has proper transmittance to efficiently emit the light generated from the organic light emitting diode display L1 to the outside.

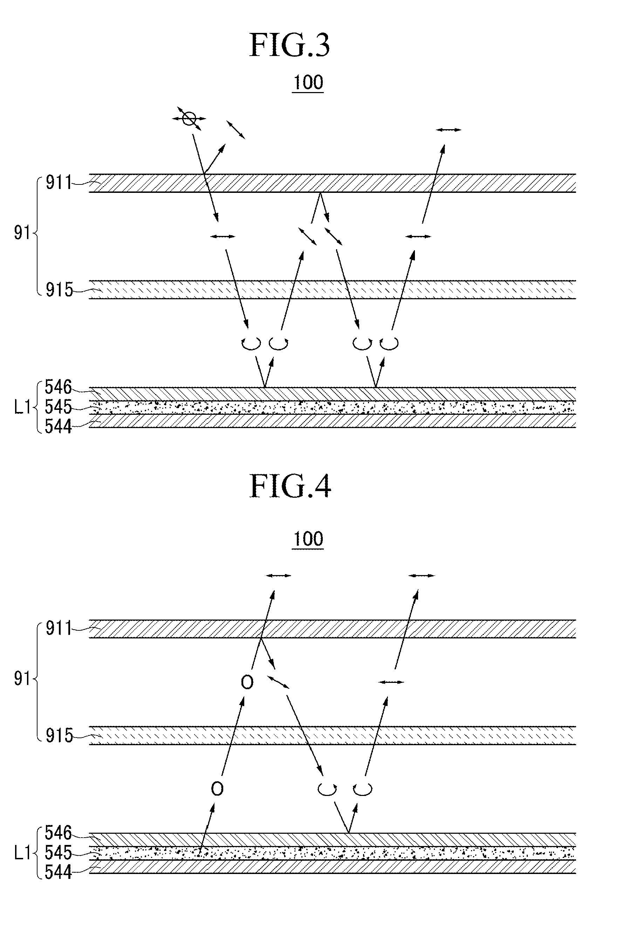

Referring now to FIGS. 3 and 4, an example of the first embodiment is provided to explain how it minimizes the loss of light emitted from the organic emission layer 545 of the organic light emitting element L1 to outside while effectively suppressing external light reflection. First, referring to FIG. 3, a path of the light from outside of the OLED display 100 through the optical member 91 will be described. The external light or light from outside of the OLED display 100 first passes through the dual brightness enhancement film 911 in the optical member 91. Some of the external light is linearly polarized along the polarization axis of the dual brightness enhancement film 911. The rest that does not pass through the dual brightness enhancement film 911 is reflected to the outside again. Thus, when the organic light emitting element L1 does not emit light, the optical member 91 functions like a mirror.

The linear polarized light is then converted into circular polarized light through the phase retardation plate 915, which, in this embodiment, is a 1/4 wavelength plate. At this time, the optical axis of the phase retardation plate 915 is deviated from the polarization axis of the dual brightness enhancement film 911 between about 40 to about 50 degrees, such as about 45 degrees.

Since the intersection angle between the axial direction of the linear polarized light and the optical axis direction of the phase retardation plate 915 is approximately 45 degrees, the linear polarized light is converted into the circular polarized light while passing through the phase retardation plate 915. In the first embodiment, the circular polarized light is right circular (clockwise) polarized light.

However, the first embodiment of the present disclosure is not limited to this direction. For example, the light passing through the phase retardation plate 915 may also be left circular (counter clockwise) polarized light.

The circular polarized light passing through the phase retardation plate 915 from outside is reflected by the organic light emitting element L1 and goes toward the phase retardation plate 915 again. As noted, the light emitting element includes a second electrode 546 and the first electrode 544. The light may be reflected by these components as well as by various metal wires in addition to the electrodes 544 and 546 of the organic light emitting element L1.

At this time, the right circular polarized light is converted into left circular polarized light while being reflected. In addition, the left circular polarized light is linearly polarized while passing through the phase retardation plate 915. At this time, the axial direction of the linear polarized light crosses the polarization axis of the dual brightness enhancement film 911. Therefore, the light is reflected without passing through the dual brightness enhancement film 911 and goes toward the organic light emitting element L1 by passing through the phase retardation plate 915 again.

Further, the linear polarized light is converted into left circular polarized light while passing through the phase retardation plate 915. Thereafter, the left circular polarized light is converted into right circular polarized light again while being reflected by the organic light emitting element L1. In addition, the right circular polarized light is linearly polarized while passing through the phase retardation plate 915. At this time, the axial direction of the linear polarized light has substantially the same direction as the polarization axis of the dual brightness enhancement film 911.

Since the light shows slightly different movements for each wavelength band, the axial direction of the linear polarized light has substantially the same direction as the polarization axis of the dual brightness enhancement film 911. Light belonging to the visible wavelength band may have substantially the same direction as the polarization axis of the dual brightness enhancement film 911 on average. Subsequently, the linear polarized light is emitted to the outside through the dual brightness enhancement film 911.

Referring now to FIG. 4, a path of the light emitted from the organic light emitting element L1 to the outside will be described. The light emitted from the organic emission layer 545 of the organic light emitting element L1 goes toward the dual brightness enhancement film 911 while passing through the second electrode 546 and the phase retardation plate 915 in sequence. At this time, various phases coexist in the light.

Some of light having the same component as the polarization axis of the dual brightness enhancement film 911 among the light passing through the phase retardation plate 915 passes through the dual brightness enhancement film 911. The rest is reflected to back to the phase retardation plate 915. The light passing through the dual brightness enhancement film 911 is linearly polarized and emitted to the outside. Meanwhile, the light reflected by the dual brightness enhancement film 911 goes toward the organic light emitting element L1 through the phase retardation plate 915.

A large portion of light may be converted into left circular polarized light while passing through the phase retardation plate 915. This is because the light with the optical axis having the same direction as the polarization axis of the dual brightness enhancement film 911 is emitted to the outside through the dual brightness enhancement film 911. Further, a large portion of light is converted into right circular polarized light while being reflected by the organic light emitting element L1. The light also may be reflected by various other metal wires in addition to the electrodes 544 and 546 of the organic light emitting element L1. The right circular polarized light is linearly polarized through the phase retardation plate 915 and the linear polarized light is emitted to the outside through the dual brightness enhancement film 911.

As such, the organic light emitting diode display 100 according to the first embodiment of the present disclosure has the mirror function and can minimize loss when the light is generated from the organic light emitting element L1. However, a large portion of light entering into the organic light emitting diode display 100 from the outside may be reflected.

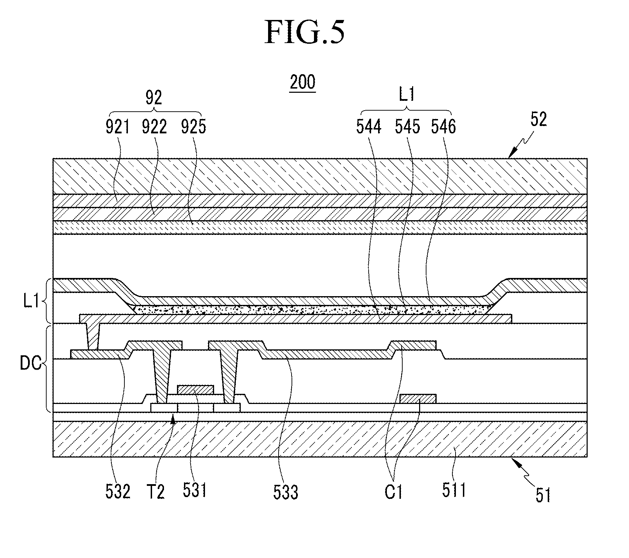

Referring now to FIG. 5, a second illustrated embodiment of the present disclosure will be described. As shown in FIG. 5, an organic light emitting diode display 200 includes an optical member 92 including a selective reflective layer 921, a polarizing plate 922, and a phase retardation plate 925. In the second embodiment of the present disclosure, the selective reflective layer 921 is referred to as a dual brightness enhancement film. That is, the optical member 92 further includes the polarizing plate 922 disposed between the dual brightness enhancement film 921 and the phase retardation plate 925.

The polarizing plate 922 has a polarization axis of the same direction as the dual brightness enhancement film 921. Accordingly, linear polarized light passing through the dual brightness enhancement film 921 can pass through the polarizing plate 922, and the linear polarized light passing through the polarizing plate 922 can pass through the dual brightness enhancement film 921. The polarizing plate 922 passes light that is parallel to the polarization axis and absorbs light that is not parallel to the polarization axis, unlike the dual brightness enhancement film 921.

By this configuration, the organic light emitting diode display 200 may have a mirror function and improve visibility by suppressing external light reflection. More specifically, the dual brightness enhancement film 921 has a mirror effect by reflecting external light when the organic light emitting element L1 does not emit the light. In addition, the polarizing plate 922 serves to suppress the external light reflection.

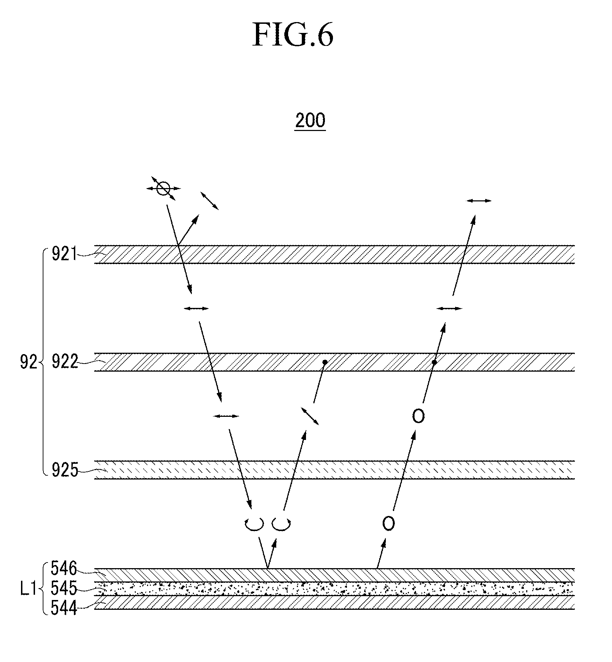

Referring now to FIG. 6, an example of a principle will be described in which the optical member 92 of the organic light emitting diode display 200 according to the second embodiment minimizes loss of light emitted from an organic emission layer 545 to the outside while effectively suppressing the external light reflection.

First, a path of light from outside through the optical member 92 will be described. The external light or light from outside first passes through the dual brightness enhancement film 921 in the optical member 92. Some of the external light is linearly polarized along the polarization axis of the dual brightness enhancement film 921 while passing through the dual brightness enhancement film 921. The rest that does not pass through the dual brightness enhancement film 921 is reflected back to the outside again.

When the organic light emitting element L1 does not emit the light because of the light reflected to the outside, the optical member 92 can perform the function of a mirror. The linear polarized light is converted into circular polarized light through the phase retardation plate 925, which is a 1/4 wavelength plate, by passing through the polarizing plate 922. At this time, the optical axis of the phase retardation plate 925 deviates from the polarization axis of the dual brightness enhancement film 921 between about 40 to about 50 degrees, such as about 45 degrees.

As such, since an intersection angle between an axial direction of the linear polarized light and the optical axis direction of the phase retardation plate 925 is approximately 45 degrees, the linear polarized light is converted into circular polarized light while passing through the phase retardation plate 925. At this time, the circular polarized light is right circular polarized light. However, the second embodiment is not limited to this direction. For example, the light passing through the phase retardation plate 925 may be left circular polarized light.

The right circular polarized light passing through the phase retardation plate 925 is reflected by the organic light emitting element L1 and goes toward the phase retardation plate 925 again. Further, the light may be reflected by the second electrode 546 and a first electrode 544 and various metal wires in addition to the electrodes 544 and 546 of the organic light emitting element L1. At this time, the right circular polarized light is converted into left circular polarized light while being reflected. In addition, the left circular polarized light is linearly polarized while passing through the phase retardation plate 925.

At this time, an axial direction of the linear polarized light crosses the polarization axis of the dual brightness enhancement film 922. Accordingly, the light is absorbed in the polarizing plate 922 without passing through the polarizing plate 922. In this way, since the external light that is reflected by the organic light emitting element L1 is absorbed in the polarizing plate 922, the organic light emitting diode display 200 can suppress the reflection of external light.

Next, a path of the light emitted from the organic light emitting element L1 to the outside will be described. The light emitted from the organic emission layer 545 of the organic light emitting element L1 goes toward the dual brightness enhancement film 922 while passing through the second electrode 546 and the phase retardation plate 925 in sequence. At this time, various phases coexist in the light.

Light having the same polarization axis as the axis of the polarizing plate 922 that passed through the phase retardation plate 925 now passes through the polarizing plate 922. The rest is absorbed in the polarizing plate 922. The linear polarized light having passed through the polarizing plate 922 passes through the dual brightness enhancement film 921 and is emitted outside. In this way, the organic light emitting diode display 200 according to the second embodiment has the mirror function and has improved visibility by suppressing reflection of external light. However, in some embodiments, the light generated from the organic light emitting element L1 may be partially lost.

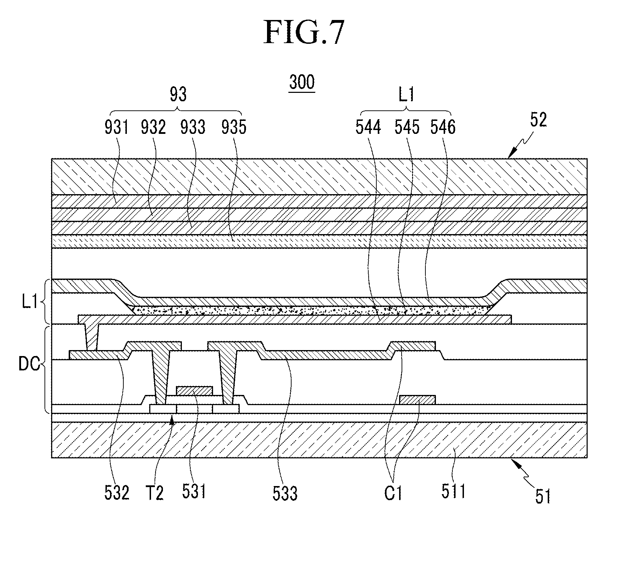

Referring now to FIG. 7, a third illustrated embodiment of the present disclosure will be described. As shown in FIG. 7, an organic light emitting diode display 300 includes an optical member 93 including a selective reflective layer 931, a polarizing plate 932, an additional dual brightness enhancement film 933, and a phase retardation plate 935. The polarizing plate 932 is disposed between the first dual brightness enhancement film 931 and the phase retardation plate 935, and the second dual brightness enhancement film 933 is disposed between the polarizing plate 932 and the phase retardation plate 935.

In the third embodiment, the selective reflective layer 931 is referred to as a first dual brightness enhancement film. The additional dual brightness enhancement film 933 is referred to as a second dual brightness enhancement film.

The polarization axes of the first dual brightness enhancement film 931, the polarizing plate 932, and the second dual brightness enhancement film 933 are the same. By this configuration, the organic light emitting diode display 300 can have a mirror function and proper transmittance to efficiently emit light generated from the organic light emitting element L1 to the outside.

Further, the organic light emitting diode display 300 can improve visibility by suppressing at least some of external light reflection. More specifically, the first dual brightness enhancement film 931 has an effect of a mirror by reflecting external light when the organic light emitting element L1 does not emit light. The second dual brightness enhancement film 933 minimizes loss of light when light generated from the organic light emitting element L1 is emitted to the outside.

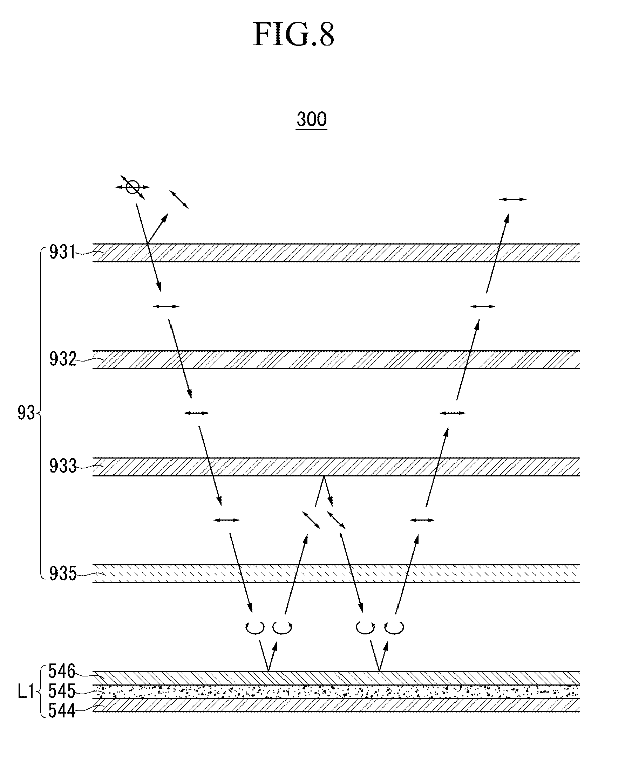

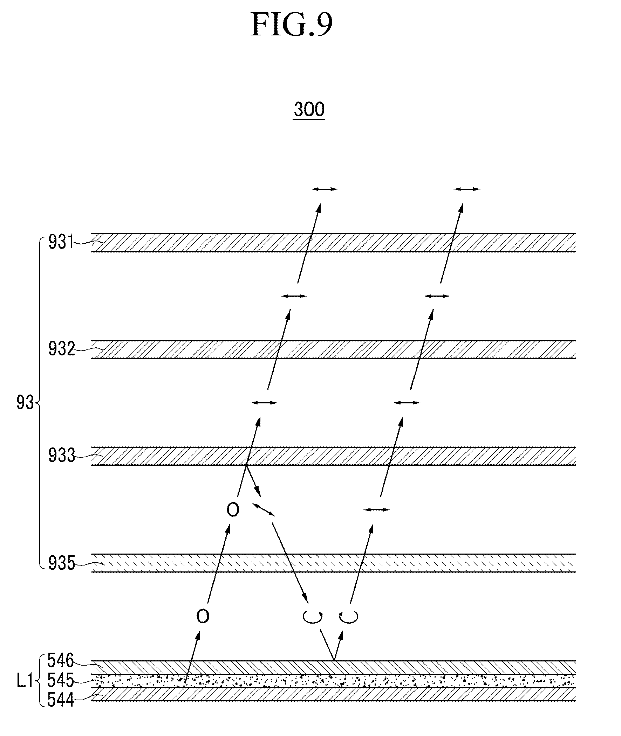

Referring now to FIGS. 8 and 9, some examples of how the third embodiment of the present disclosure minimizes the loss of the light emitted from the organic emission layer 545 to the outside while effectively suppressing the external light reflection. First, referring to FIG. 8, a path of the light from the outside through the optical member 93 will be described.

The external light first passes through the first dual brightness enhancement film 931 in the optical member 93. Some of the external light is linearly polarized along a polarization axis of the first dual brightness enhancement film 931 while passing through the first dual brightness enhancement film 931. The rest that does not pass through the first dual brightness enhancement film 931 is reflected back to the outside. Thus, when the organic light emitting element L1 does not emit light, the optical member 93 can perform the function of a mirror.

The linear polarized light is converted into circular polarized light through the phase retardation plate 935, which is a 1/4 wavelength plate by passing through the polarizing plate 932 and the second dual brightness enhancement film 933 in sequence. At this time, the optical axis of the phase retardation plate 935 deviates from the polarization axis of the first dual brightness enhancement film 931, the polarizing plate 932, and the second dual brightness enhancement film 933 between about 40 to about 50 degrees, such as about 45 degrees.

As such, since an intersection angle between an axial direction of the linear polarized light and the optical axis direction of the phase retardation plate 935 is approximately 45 degrees, the linear polarized light is converted into the circular polarized light while passing through the phase retardation plate 935. At this time, the circular polarized light is right circular polarized light. However, the third embodiment is not limited to this direction. For example, the light passing through the phase retardation plate 935 may be left circular polarized light.

The right circular polarized light passing through the phase retardation plate 935 is reflected by the organic light emitting element L1 and goes toward the phase retardation plate 935 again. Further, the light may be reflected by the second electrode 546 and a first electrode 544, as well as various metal wires in addition to the electrodes 544 and 546 of the organic light emitting element L1. At this time, the right circular polarized light is converted into left circular polarized light while being reflected. In addition, the left circular polarized light is linearly polarized while passing through the phase retardation plate 935.

At this time, the axial direction of the linear polarized light crosses the polarization axis of the second dual brightness enhancement film 933. Therefore, the light is reflected without passing through the second dual brightness enhancement film 933 and goes toward the organic light emitting element L1 by passing through the phase retardation plate 935 again.

Further, the linear polarized light is converted into left circular polarized light while passing through the phase retardation plate 935. Thereafter, the left circular polarized light is converted into right circular polarized light again while being reflected by the organic light emitting element L1. In addition, the right circular polarized light is linearly polarized while passing through the phase retardation plate 935. At this time, the axial direction of the linear polarized light has substantially the same direction as the polarization axis of the second dual brightness enhancement film 933. Herein, since the light shows slightly different movements for each wavelength band, the axial direction of the linear polarized light has substantially the same direction as the polarization axis of the second dual brightness enhancement film 933.

Light belonging to the visible wavelength band has substantially the same direction as the polarization axis of the second dual brightness enhancement film 933 on average. Accordingly, the linear polarized light is emitted outside by passing through the second dual brightness enhancement film 933, the polarizing plate 932, and the first dual brightness enhancement film 931 in sequence.

Referring now to FIG. 9, a path of the light emitted from the organic light emitting element L1 to the outside will be described. The light emitted from the organic emission layer 545 of the organic light emitting element L1 goes toward the second dual brightness enhancement film 933 while passing through the second electrode 546 and the phase retardation plate 935 in sequence. At this time, various phases coexist in the light.

Some of light having the same component as the polarization axis of the second dual brightness enhancement film 933 among the light passing through the phase retardation plate 935 passes through the second dual brightness enhancement film 933. The rest is reflected back toward the phase retardation plate 935. Herein, the light passing through the second dual brightness enhancement film 933 is linearly polarized, and is emitted outside by passing through the polarizing plate 932 and the first dual brightness enhancement film 931 in sequence.

Meanwhile, the light reflected by the dual brightness enhancement film 933 goes toward the organic light emitting element L1 through the phase retardation plate 935. At this time, a large portion of light may be converted into left circular polarized light while passing through the phase retardation plate 935. This is because the light with the optical axis having the same direction as the polarization axis of the second dual brightness enhancement film 933 is finally emitted outside by passing through the second dual brightness enhancement film 933.

Further, a large portion of light is converted into right circular polarized light while being reflected by the organic light emitting element L1. The right circular polarized light is linearly polarized while passing through the phase retardation plate 935, and the linear polarized light is emitted outside by passing through the second dual brightness enhancement film 933, the polarizing plate 932, and the first dual brightness enhancement film 931 in sequence.

As such, the organic light emitting diode display 300 according to the third illustrated embodiment of the present disclosure has the mirror function and can minimize loss when the light is generated from the organic light emitting element L1. Further, the external light reflection can be suppressed to some extent in the course of reflection and passing through the first dual brightness enhancement film 931, the polarizing plate 932, and the second dual brightness enhancement film 933.

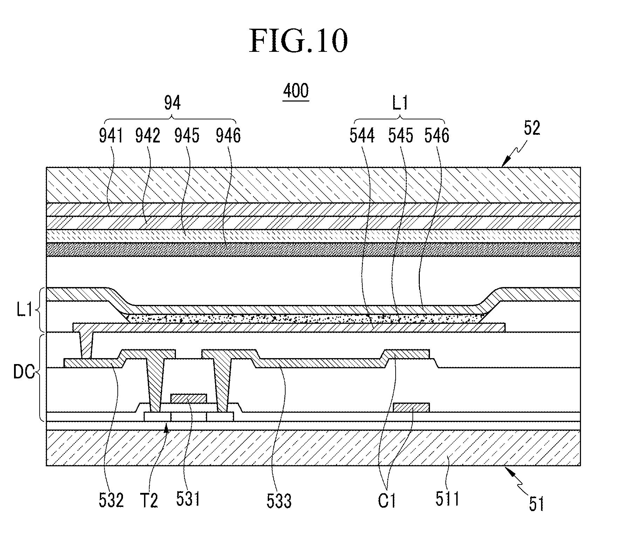

Referring now to FIG. 10, a fourth illustrated embodiment of the present disclosure will be described. As shown in FIG. 10, an organic light emitting diode display 400 includes an optical member 94 including a selective reflective layer 941, a polarizing plate 942, a phase retardation plate 945, and a cholesteric liquid crystal (CLC) layer 946. The polarizing plate 942 is disposed between the dual brightness enhancement film 941 and the phase retardation plate 945, and the cholesteric liquid crystal layer 946 is disposed between the phase retardation plate 945 and an organic light emitting element L1. The optical member 94 is shown to include the polarizing plate 942, but the fourth exemplary embodiment of the present disclosure is not limited to this configuration. For example, the polarizing plate of the optical member 94 may be omitted.

The polarizing plate 942 has a polarization axis of the same direction as the polarization axis of the selective reflective layer 941. Hereinafter, in the fourth embodiment of the present disclosure, the selective reflective layer 941 is referred to as a dual brightness enhancement film.

Although cholesteric liquid crystals have a layered structure like smectic liquid crystals, molecules along a long axis have an equilibrium arrangement similar to nematic liquid crystals in a plane. More specifically, the cholesteric liquid crystals have a structure in which elongated molecules are arranged in order in a long axis direction in one plane and an arrangement orientation of a molecular axis is slightly deviated in a direction vertical to the plane, that is, a structure in which a molecular arrangement orientation circles a helical curve. Therefore, the liquid crystals have a helical structure on the whole. As a result, the cholesteric liquid crystals have specific characteristics, i.e., optical rotary power, selective light dispersion, and circular dichroism. Accordingly, the cholesteric liquid crystal layer 946 may selectively transmit or reflect circular polarized light. In the fourth embodiment, the cholesteric liquid crystal layer 946 transmits right circular polarized light and reflects left circular polarized light.

By this configuration, the organic light emitting diode display 400 can have a mirror function and proper transmittance to efficiently emit light generated from the organic light emitting element L1 to the outside. Further, the organic light emitting diode display 400 can improve visibility by suppressing at least some external light reflection. More specifically, the dual brightness enhancement film 941 has a mirror effect by reflecting external light when the organic light emitting element L1 does not emit light. The cholesteric liquid crystal layer 946 minimizes loss of light when the light generated from the organic light emitting element L1 is emitted to the outside.

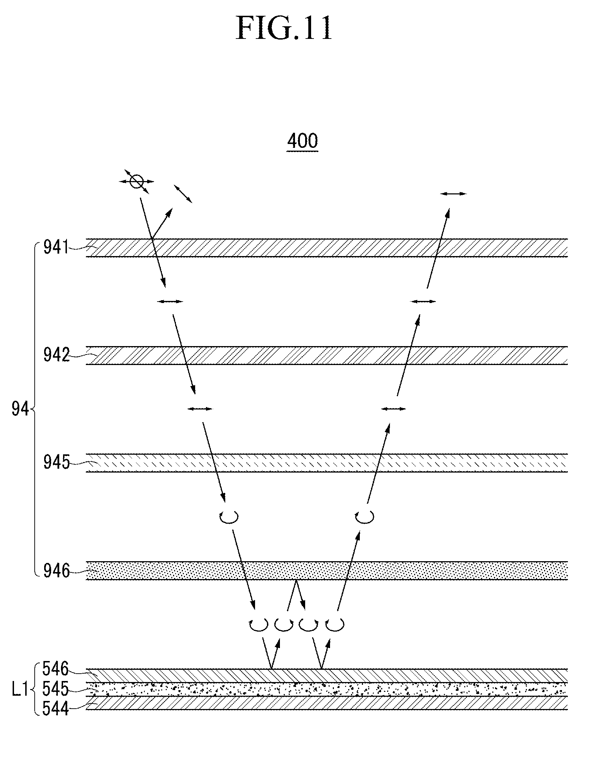

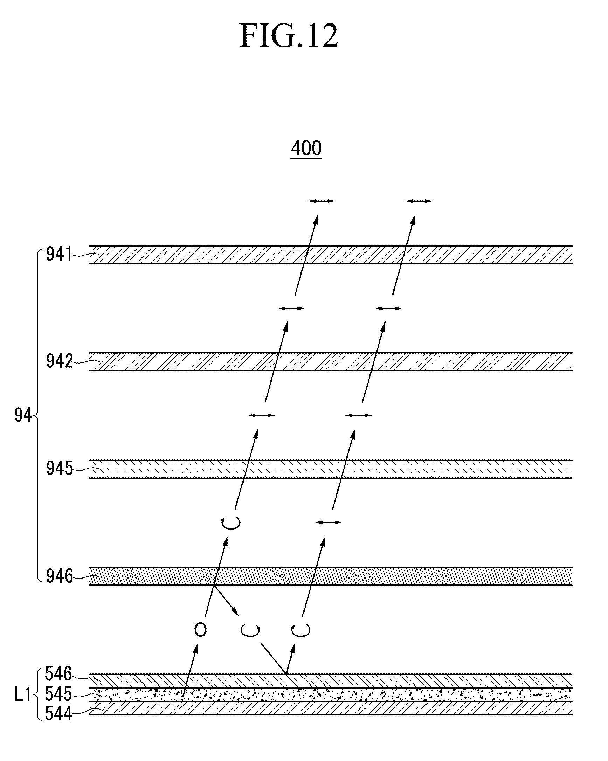

Referring now to FIGS. 11 and 12, some examples of how the fourth embodiment of the present disclosure minimizes the loss of light emitted from an organic emission layer 545 to the outside while effectively suppressing the external light reflection. First, referring to FIG. 11, a path of light from the outside through the optical member 94 will be described. The external light first passes through the dual brightness enhancement film 941 in the optical member 94.

Some of the external light is linearly polarized in a polarization axis of the dual brightness enhancement film 941 while passing through the dual brightness enhancement film 941. The rest that does not pass through the dual brightness enhancement film 941 is reflected back to the outside. The optical member 94 can perform a mirror function , when the organic light emitting element L1 does not emit light because the light is reflected to the outside.

The linear polarized light is converted into circular polarized light through the phase retardation plate 945, which is a 1/4 wavelength plate, by passing through the polarizing plate 942. In some embodiments, the polarizing plate 942 may be omitted. At this time, an optical axis of the phase retardation plate 945 deviates from the polarization axis of the dual brightness enhancement film 941 between about 40 to about 50 degrees, such as about 45 degrees.

As such, since an intersection angle between an axial direction of the linear polarized light and the optical axis direction of the phase retardation plate 945 is approximately 45 degrees, the linear polarized light is converted into the circular polarized light while passing through the phase retardation plate 945. At this time, the circular polarized light is right circular polarized light. However, the fourth embodiment of the present disclosure is not limited to this direction. For example, the phase retardation plate 945 may be disposed such that the light passing through the phase retardation plate 945 becomes left circular polarized light.

The right circular polarized light passes through the cholesteric liquid crystal layer 946. The cholesteric liquid crystal layer 946 is configured to pass the right circular polarized light and reflect the left circular polarized light. However, the fourth embodiment is not limited to this configuration. For example, the cholesteric liquid crystal layer 946 may pass the left circular polarized light and reflect the right circular polarized light. However, in this case, the light passing through the phase retardation plate 945 must be the left circular polarized light. That is, the cholesteric liquid crystal layer 946 must be able to pass the circular polarized light through the dual brightness enhancement film 941 and the phase retardation plate 945.

The right circular polarized light passing through the cholesteric liquid crystal layer 946 is reflected by the organic light emitting element L1 and goes toward the cholesteric liquid crystal layer 946 again. At this time, the right circular polarized light is converted into left circular polarized light while being reflected. Accordingly, the light is reflected without passing through the cholesteric liquid crystal layer 946 and goes toward the organic light emitting element L1 again. Further, the light may be reflected by the second electrode 546 and the first electrode 544, as well as by various metal wires in addition to the electrodes 544 and 546 of the organic light emitting element L1.

Once again, the left circular polarized light is converted into right circular polarized light while being reflected by the organic light emitting element L1. In addition, the right circular polarized light is converted into the linear polarized light through the phase retardation plate 945 by passing through the cholesteric liquid crystal layer 946. At this time, the linear polarized light has substantially the same axial direction as the polarization axis of the polarizing plate 942. Herein, since the light shows slightly different movements for each wavelength band, the axial direction of the linear polarized light has substantially the same direction as the polarization axis of the polarizing plate 942. Light belonging to the visible wavelength band has substantially the same direction as the polarization axis of the polarizing plate 942 on average. Therefore, the linear polarized light is emitted outside while passing through the polarizing plate 942 and the dual brightness enhancement film 941 in sequence.

Next, referring now to FIG. 12, a path of the light emitted from the organic light emitting element L1 to the outside will be described. The light emitted from the organic emission layer 545 goes toward the cholesteric liquid crystal layer 946 through the second electrode 546. At this time, various phases coexist in the light. Light having a right circular polarized light component among the light passing through the second electrode 546 goes toward the phase retardation plate 945 through the cholesteric liquid crystal layer 946. Light having a left circular polarized light component is reflected toward the organic light emitting element L1 again. The light passing through the cholesteric liquid crystal layer 946 is linearly polarized while passing through the phase retardation plate 945, and the linear polarized light is emitted outside by passing through the polarizing plate 942 and the dual brightness enhancement film 941.

Meanwhile, the light that goes toward the organic light emitting element L1 is converted into right circular polarized light while being reflected. Further, the light may be reflected by various metal wires in addition to the electrodes 544 and 546 of the organic light emitting element L1. The right circular polarized light is emitted outside by passing through the cholesteric liquid crystal layer 946, the phase retardation plate 945, the polarizing plate 942, and the dual brightness enhancement film 941 in sequence.

As such, the organic light emitting diode display 400 according to the fourth illustrated embodiment of the present disclosure has the mirror function and can minimize loss when the light generated from the organic light emitting element L1 is emitted outside. Further, the external light reflection can be suppressed in the course of reflection and passing through the dual brightness enhancement film 941, the polarizing plate 942, the phase retardation plate 945, and the cholesteric liquid crystal layer 946.

Referring now to Table 1 shown below, experimental examples and a comparative example are provided. The experimental examples include Experimental Example 1, Experimental Example 2, Experimental Example 3, and Experimental Example 4 according to the above-mentioned first to fourth illustrated embodiments, respectively. The comparative example includes a known optical member constituted by a polarizing plate and a phase retardation plate.

Transmittances of the experimental examples and the comparative example are shown in the following Table 1.

**(Table 1)**

| | Experimental Example1 | Experimental Example2 | Experimental Example3 | Experimental Example4 | Comparative Example |
|---|---|---|---|---|---|
| White light | 70% | 45% | 63% | 63% | 45% |
| Red light | 70% | 45% | 64% | 64% | 45% |
| Green light | 70% | 45% | 63% | 63% | 45% |
| Blue light | 69% | 43% | 60% | 60% | 43% |

As shown in Table 1, each of the experimental examples has a mirror function, and in addition, has the same or better transmittance than the comparative example. Accordingly, the organic light emitting diode display may have proper (or better) transmittance and visibility in addition to the mirror function.

## Claims

1. An organic light emitting diode display comprising:
a substrate member (51);
an organic light emitting element (L1) formed on the substrate member (51);
a phase retardation plate (915, 925, 935, 945) formed on the organic light emitting element (L1); and
a selective reflective layer (911, 921, 931, 941) formed on the phase retardation plate (915, 925, 935, 945), wherein the selective reflective layer (911, 921, 931, 941) is adapted to selectively pass some of light therethrough and to reflect the rest.

2. The organic light emitting diode display of claim 11, wherein
the selective reflective layer (911, 921, 931, 941) is adapted to pass light that is parallel to a polarization axis of the selective reflective layer (911, 921, 931, 941) and to reflect light that is not parallel to the polarization axis of the selective reflective layer (911, 921, 931, 941) such that light that passes through the selective reflective layer (911, 921, 931, 941) is linearly polarized.

3. The organic light emitting diode display of claim 22, wherein
the phase retardation plate (915, 925, 935, 945) comprises an optical axis, wherein an intersection angle between the optical axis and the polarization axis of the selective reflective layer (911, 921, 931, 941)is from about 40 to about 50 degrees.

4. The organic light emitting diode display of one of the preceding claims3, wherein the phase retardation plate (915, 925, 935, 945) is adapted to circularly polarize linearly polarized light or to linearly polarize circularly polarized light, wherein the circularly polarized light is either one of left circular polarized light or right circular polarized light.

5. The organic light emitting diode display of one of the preceding claims4, wherein the organic light emitting element (L1) is adapted to reflect light incident thereon and to reverse direction of circular polarization of light reflecting thereof.

6. The organic light emitting diode display of claim 2 or one of the claims 3 through 5 as dependent on claim 22, further comprising:
a polarizing plate (922, 932, 942) disposed between the selective reflective layer (921, 931, 941) and the phase retardation plate (925, 935, 945),
wherein the polarizing plate has a polarization axis in the same direction as the polarization axis of the selective reflective layer (921, 931, 941).

7. The organic light emitting diode display of claim6 6, further comprising
a second selective reflective layer (933) disposed between the polarizing plate (932) and the phase retardation plate (935),
wherein the second selective reflective layer (933) has a polarization axis in the same direction as the polarization axis of the selective reflective layer (931) and the polarizing plate (932).

8. The organic light emitting diode display of claim6 6, further comprising
a cholesteric liquid crystal (CLC) layer (946) disposed between the phase retardation plate (945) and the organic light emitting element (L1).

9. The organic light emitting diode display of claim8 8, wherein
the cholesteric liquid crystal layer (946) is adapted to pass either one of left circular polarized light or right circular polarized light and to reflect the other.

10. The organic light emitting diode display of one of the claims9 8 or 9, wherein
the cholesteric liquid crystal layer (946) is arranged such that light that is circular polarized through the polarizing plate (942) and the phase retardation plate (945) in sequence can pass the cholesteric liquid crystal layer (946).

11. The organic light emitting diode display of one of the preceding claims 1, wherein the selective reflective layer (911, 921, 931, 941) comprises a dual brightness enhancement film (DBEF).

12. The organic light emitting diode display of one of the preceding claims1, wherein the phase retardation plate (915, 925, 935, 945) comprises a 1/4 wavelength plate.

13. The organic light emitting diode display of one of the preceding claims1, further comprising a cover substrate (52) configured to bond with the substrate member (51) via a sealant and to enclose a space therein.

14. The organic light emitting diode display of claim13 13, wherein the organic light emitting element (L1) and the phase retardation plate (915, 925, 935, 945) are enclosed within the space.

15. The organic light emitting diode display of one of the claims 13 or 1413, wherein the selective reflective layer (911, 921, 931, 941) is enclosed within the space.
